# EUROPEAN PATENT APPLICATION

(11) **EP 3 425 791 A1**
(43) Date of publication of application: **09.01.2019**
(21) Application number: 17179850.7
(22) Date of filing: 05.07.2017
(51) Int. Cl.: H02P 25/08

(54) **METHOD AND APPARATUS FOR CONTROLLING THE CURRENT FLOW OF AT LEAST ONE PHASE WINDING OF A SWITCHED RELUCTANCE MOTOR**

(71) Applicant: Brose Fahrzeugteile GmbH & Co. Kommanditgesellschaft, Würzburg, 97076 Würzburg (DE); The Technical University of Cluj-Napoca, 400114 Cluj-Napoca (RO)
(72) Inventor: POP, Adrian-Cornel, 97070 Würzburg (DE); VINTILOIU, Ioana, 97076 Würzburg (DE); MARTIS, Claudia, 400496 Cluj-Napoca (RO); RUSU, Tiberiu, 97076 Würzburg (DE)
(74) Representative: Isarpatent

(57) **Abstract**

The invention relates to an apparatus and method for controlling the current flow of at least one phase winding of a switched reluctance motor during at least one dwell period of the motor, wherein the dwell period starts with a turn-on angle of the motor and ends with the turn-off angle of the motor, wherein the dwell period is divided in a first subinterval comprising a first reference current, a second subinterval comprising a second reference current and a third subinterval comprising a third reference current, wherein the flow of the first reference current is controlled based on at least one motor-efficiency parameter which depends on the efficiency of the motor, wherein the flow of the second reference current is controlled based on at least one torque-parameter which depends on the torque of the motor to control the torque production of the motor, and/or wherein the flow of the third reference current is controlled based on at least one noise-and/or-vibration-parameter which depends on an electromagnetic force produced by the motor to reduce noise and/or vibration of the motor.

## Description

### FIELD OF THE INVENTION

The present invention relates to a method and apparatus for controlling the current flow of at least one phase winding of a switched reluctance motor.

### TECHNICAL BACKGROUND

A switched reluctance machine (SRM) is generally a machine in which torque is produced by the tendency of its movable part to move into a position where the inductance of an excited winding of the machine is maximized. A conventional switched reluctance machine comprises a stator including stator poles and a rotor, comprising rotor poles, and coupled to a rotatable shaft co-axial with the principal axis of the stator. Associated with each stator pole is a wound coil of wire, e.g. a copper wire. The coils of the stator poles can be coupled together to form a multi-phase machine, e.g. a three phase machine. When a phase and thus the coils of its corresponding stator poles is energized current will flow through the coils of its stator poles and an electromagnetic force is produced between the energised stator poles of the phase and the rotor poles which will produce a torque. The torque is produced as a result of the rotor tendency to align its poles with the excited stator poles thus minimizing the reluctance of the so formed magnetic circuit.

In US 5,742,139 A a control circuit for a motor having at least two windings is used to optimize noise reduction by controlling the de-energization of each winding in a two-stage decay. The duration of the two-stage decay and particularly the first decaying current portion is controlled by a controller operatively coupled to a switch device. The current portion is varied between the various phases of the motor to provide noise reduction.

Further, US 5, 923, 141 A discloses a current control circuit for a switched reluctance machine which provides corner shaping at the end of the active conduction period of a phase in which the phase winding is energized. The pulse width modulated firing pulses are gradually reduced in duty cycle so that the transition period between the current in the winding in the active period and the decay of the current in a ramp down period is smoothened to reduce the forces leading to vibration and acoustic noise.

Moreover, in US 5,461,295 A an apparatus for controlling the current profile in a single of polyphase SRM during the active portion of a phase is disclosed.

### SUMMARY OF THE INVENTION

Against this background, an objective of the present invention is to provide an improved method and apparatus for controlling the current flow of at least one phase winding of a switched reluctance motor.

This objective is achieved according to the invention by a method having the features of claim 1 and an apparatus having the features of claim 8.

A method is provided for controlling the current flow of at least one phase winding of a switched reluctance motor during at least one dwell period of the motor, wherein the dwell period starts with a turn-on angle of the motor and ends with the turn-off angle of the motor,
wherein the dwell period is divided in a first subinterval comprising a first reference current, a second subinterval comprising a second reference current and a third subinterval comprising a third reference current,
wherein the flow of the first reference current is controlled based on at least one motor-efficiency parameter which depends directly or indirectly on the efficiency of the motor, wherein the flow of the second reference current is controlled based on at least one torque-parameter which depends directly or indirectly on the torque of the motor to control the torque production of the motor, and/or
wherein the flow of the third reference current is controlled based on at least one noise-and/or-vibration-parameter which depends directly or indirectly on an electromagnetic force produced by the motor to reduce noise and/or vibration of the motor.

Further, an apparatus is provided for controlling the current flow of at least one phase winding of a switched reluctance motor during at least one dwell period of the motor, wherein the dwell period starts with a turn-on angle of the motor and ends with the turn-off angle of the motor, wherein the dwell period is divided in a first subinterval comprising a first reference current, a second subinterval comprising a second reference current and a third subinterval comprising a third reference current, comprising:
- first sensing means for sensing the angle of the motor and/or the corresponding stroke of the motor;
- means for determining the first, second and third subinterval based on the angle of the motor and/or the corresponding stroke of the motor sensed by the first sensing means;
- second sensing means for sensing at least one motor-efficiency parameter which depends directly or indirectly on the efficiency of the motor, at least one torque-parameter which depends directly or indirectly on the torque of the motor, and/or at least one noise-and/or-vibration-parameter which depends directly or indirectly on an electromagnetic force produced by the motor;
- control means for controlling the flow of the first reference current based on the at least one motor-efficiency parameter, the flow of the second reference current based on the at least one torque-parameter, and/or the flow of the third reference current based on the least one noise-and/or-vibration-parameter during the third subinterval.

The concept underlying the invention entails that an dwell period of a switched reluctance motor is divided in three subintervals, which are controllable based on corresponding parameters independent of each other, so that the reference current of the first subinterval is controllable to increase the efficiency of the motor, the reference current of the second subinterval is controllable to improve torque generation while still permitting preferably a sufficient efficiency of the motor and the reference current of the third subinterval is controllable to improve noise, vibration and harshness characteristics.

Advantageous embodiments and developments of the invention emerge from the additional subordinate claims and from the description with reference to the drawing figures.

According to an embodiment of the invention, the at least one motor-efficiency parameter to control the flow of the first reference current to increase the motor efficiency during the first subinterval is a conduction loss of the at least one phase winding, for example a copper loss in case of a copper winding, a load of the motor and/or a working speed of the motor. Thus, over the first subinterval the motor efficiency can be optimized, as this is the interval when the rotor of the motor is moving from an un-aligned position or zero torque and starts to produce torque. As the torque is very low, the level of the reference current can be optimized such that coinduction losses, e.g. copper losses, of the at least one phase winding are kept low, while slowly energizing the phase. The first subinterval starts at a turn-on angle of the motor or zero torque and ends before the motor reaches a maximum predetermined torque.

In another embodiment of the invention, the least one torque-parameter to control the flow of the second reference current to control torque production of the motor is the torque of the motor, a tangential component of an electromagnetic force produced by the motor, a radial component of an electromagnetic force produced by the motor, a load of the motor and/or a working speed of the motor. Since the second subinterval is the interval at which the motor operates at its maximum torque capability, the flow of the second reference current is controlled to inject as much current as needed to develop or to provide the required torque or maximum torque of the motor. Based on the at least one torque parameter the flow of the second reference current can be controlled, in particular increased, to provide a corresponding maximum torque. The radial component of the electromagnetic force produced by the motor can be also increased. However, the radial component is still significantly lower than a maximum possible value which happens to be when the rotor pole of the motor is perfectly aligned with an exited stator pole of the motor.

According to a further embodiment of the invention, the at least one noise-and/or-vibration-parameter to control the flow of the third reference current to reduce noise and/or vibration of the motor is a tangential component of an electromagnetic force produced by the motor, a radial component of an electromagnetic force produced by the motor, a load of the motor and/or a working speed of the motor. The flow of the third reference current can be controlled so that the radial component is decreased or minimized while still developing the remaining portion of the torque which is needed to achieve a required average torque value. This has the advantage that noise, vibration and harshness can be reduced in the third subinterval while still torque is developed, and thus an average torque value larger than zero can be provided.

However, in an embodiment of the invention, the flow of the third reference current can be controlled so that the torque is reduced to a predetermined torque value while the radial component is minimized, wherein the predetermined torque value can be larger than zero or zero as well, depending on the function or use of the motor.

In another embodiment of the invention, the second reference current is a maximum current and the first reference current and the third reference current are equally great or different in size. As mentioned the second subinterval can be defined as the subinterval in which the motor can operate at maximum torque. Further, in contrast to a conventional one-state current function as will be described below, at least two or three different reference currents which are larger than zero can be applied to the subintervals of the dwell period of the motor.

According to another embodiment of the invention the third reference current is decreased by soft-chopping or hard chopping to zero or preferably a current value larger than zero. Soft-chopping of the flow of the third reference current has the advantage that the increased inductance can be exploited as depending on the working speed and load. Further a reduced phase voltage or zero voltage is allowed in the third subinterval which results in improvement in terms of the power factor.

In an embodiment of the invention the control means of the apparatus comprises a storing means in which a look-up table for a flow of the first, second and/or third reference current is stored dependent on the at least one motor-efficiency parameter, the at least one torque-parameter, and the at least one noise-and/or-vibration-parameter, respectively. The control means can control the reference current of the first, second and/or third subinterval based on the look-up table corresponding to the parameter or parameters sensed by the sensing means.

In a further embodiment of the invention, the control means of the apparatus comprises a calculation means to calculate a flow of the first, second and/or third reference current dependent on the at least one motor-efficiency parameter, the at least one torque-parameter, and the at least one noise- and/or-vibration-parameter, respectively. Thus alternatively or in addition to the look-up table or tables, the calculation means can calculate a flow of the reference current of the first, second and/or third subinterval or interpolate a flow of the reference current of the first, second and/or third subinterval based on a corresponding look-up table etc..

### CONTENT OF THE DRAWINGS

The present invention is explained below in greater detail with the aid of embodiments specified in the schematic figures in the drawings. These are as follows:
- Fig. 1a: shows a diagram illustrating an example of current and voltage waveforms depending on the angle of the motor, e.g. a switched reluctance motor (SRM);
- Fig. 1b: shows a diagram illustrating the angle and corresponding stroke depending on the normalized torque and radial force per phase of a motor, when the phase is supplied with constant current;
- Fig. 2: shows a diagram in which a conventional flow of a reference current and a flow of reference current according to an embodiment of the invention is applied to a switched reluctance motor (SRM);
- Fig. 3: shows a diagram in which a flow of current according to another embodiment of the invention is illustrated and soft-chopping of the current;
- Fig. 4: shows a diagram in which a flow of current according to a further embodiment of the invention is illustrated and soft-chopping of the current;
- Fig. 5: shows a diagram in which a flow of current according to an embodiment of the invention is illustrated and soft-chopping of the current, wherein the three current states are not kept constant;
- Fig. 6: shows a diagram in which a flow of current according Fig. 3 of the invention is illustrated and hard-chopping of the current;
- Fig. 7: shows a diagram in which a conventional flow of current is illustrated and soft-chopping of the current;
- Fig. 8: shows a diagram in which a flow of torque T of a conventional current control and of an inventive current control with soft-chopping and hard-chopping of the current is illustrated;
- Fig. 9: shows a diagram in which a flow of a radial force of the motor of a conventional current control and of an inventive current control with soft-chopping and hard-chopping of the current is illustrated;
- Fig. 10: shows a further diagram in which a flow of a radial force of the motor of a conventional current control and of an inventive current control with soft-chopping and hard-chopping of the current is illustrated, wherein the minimization of the radial force had the highest weight in the weighted objective function;
- Fig. 11: shows a diagram in which the radial force per phase of the motor depending on the stroke of the switched reluctance motor of a conventional one-state rectangular hysteresis current control, an inventive current control with soft-chopping and hard-chopping of the current is illustrated;
- Fig. 12: shows a diagram in which the flow of the amplitude of the harmonic order of a conventional current control and of an inventive current control with soft-chopping of the current is illustrated;
- Fig. 13: shows a diagram in which the harmonic spectrum of the radial force in the one-state and three-state is illustrated;
- Fig. 14: shows a diagram in which the flow of the amplitude of the harmonic order of an inventive current control with soft-chopping and hart chopping is illustrated;
- Fig. 15: shows a schematic sketch of an apparatus for controlling the current flow of at least one phase winding of a switched reluctance motor according to an embodiment of the invention; and
- Fig. 16: shows a diagram illustrating an example of controlling the current flow of at least one phase winding of a switched reluctance motor according to an embodiment of the invention.

The accompanying drawings should convey further understanding of the embodiments of the invention. They illustrate embodiments of the invention and clarify the principles and concepts behind the invention in conjunction with the description. Other embodiments and many of the described advantages are apparent with respect to the drawings. The elements of the drawings are not necessarily illustrated true to scale in relation to each other.

In the figures in the drawing, the same elements, features and components, or those serving the same function and having the same effect, are provided with the same reference numerals in each case - unless otherwise specified.

### DESCRIPTION OF EMBODIMENTS

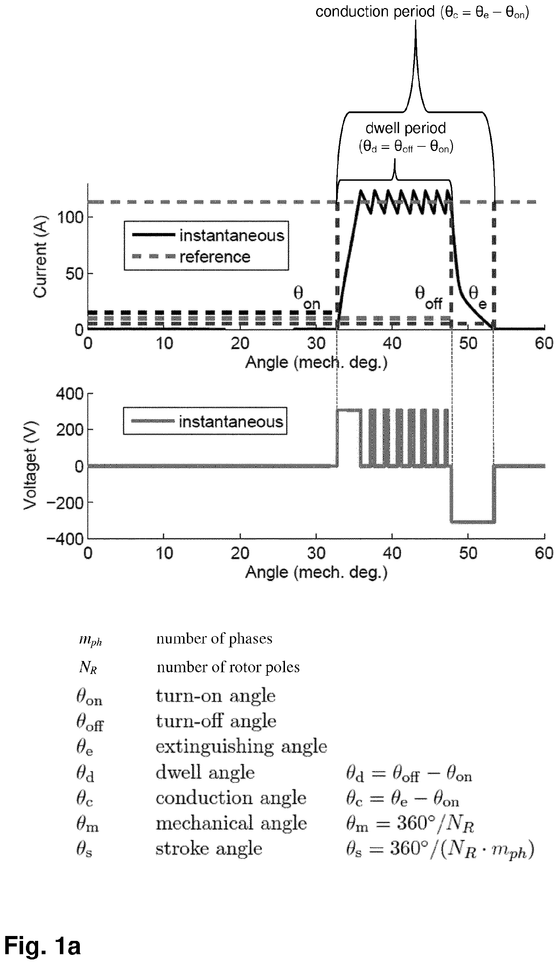

In Fig. 1a, an example of current and voltage waveforms depending on the angle of the motor, e.g. a switched reluctance motor (SRM), are illustrated.

The dwell period dwell period is the period between a turn-on angle θₒₙ and a turn-off angle θ_{off} of the motor. The dwell angle θ_{d} is defined as turn-off angle 6_{off} minus turn-on angle θₒₙ.

Further, the conduction period is the period between a turn-on angle θₒₙ and an extinguishing angle θₑ of the motor. The conduction angle θ_{c} is defined as extinguishing angle θₑ minus turn-on angle θₒₙ.

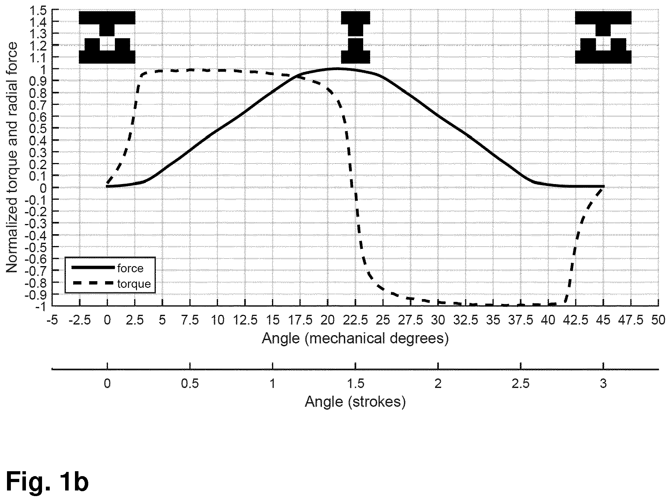

Furthermore, in Fig. 1b a diagram is shown illustrating the angle and corresponding stroke depending on the normalized torque and radial force per phase of the motor, e.g., a switched reluctance motor (SRM), when the phase is supplied with constant current. One rotor pole of the motor moves from the perfectly unaligned position to the next unaligned position.

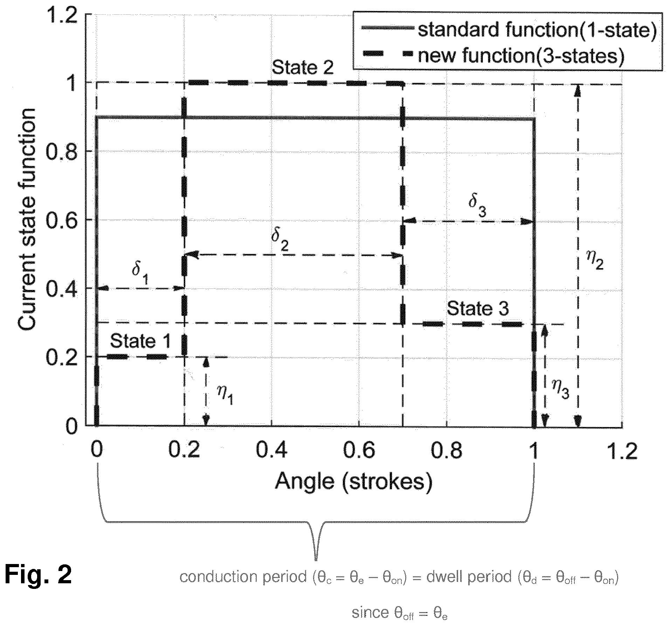

Fig. 2 shows a diagram in which a conventional flow of a reference current and a flow of a reference current according to the invention applied to a switched reluctance motor (SRM) is illustrated depending on the angle of the motor during a so called conduction period.

As mentioned before with respect to Fig. 1 the dwell period is the period between a turn-on angle θₒₙ and a turn-off angle θ_{off} of the motor and further the conduction period is the period between a turn-on angle θₒₙ and an extinguishing angle θₑ of the motor.

In Fig. 2 the X-axis indicates the angle and thus stroke S of the motor and the Y-axis indicates the current in Ampere applied to the switched reluctance motor (SRM). In the example as illustrate in Fig. 2 a stroke S = 0 corresponds to the turn-on angle and a stroke S = 1 corresponds to the turn-off angle of the switched reluctance motor (SRM). However, the invention is not restricted to the example illustrated in Fig. 2. One stroke is normally calculated as 360°/(N_{R}*mₚₕ), with N_{R} the number of rotor poles and mₚₕ the number of phases as, mentioned before in Fig. 1. For example N_{R}=8, mₚₕ=3 result in 1 stroke=15°.

One dwell period can be equal, greater or smaller as 1 stroke. This applies to all embodiments of the invention.

The conduction period is a bit longer than the dwell period between the turn-on angle θₒₙ and the turn-off angle θ_{off}, since after the turn-off angle θ_{off} there will still be current in the phase during the so-called de-fluxing period. During this period, the voltage is reversed and the current will decrease as fast as possible from its value in the "turn-off" point to zero.

The solid line indicates a standard function of a reference current applied to the motor depending on the angle of the motor and the corresponding stroke S of the motor. This standard function is referred to as one-state-current function.

On the other hand the dashed line indicates the new function of a reference current applied to the motor depending on the angle of the motor and the corresponding stroke S of the motor according to the invention. As shown in the example in Fig. 2, the dwell period is divided in three subintervals δ₁, δ₂, δ₃ as will be described in the following in more detail. This new function is referred to as three-state-current function, since in each subinterval δ₁, δ₂ and δ₃ a different reference current can be applied.

It is commonly known that switched reluctance motors (SRM) suffer from the problem of high radiated noise which results in bad noise, vibration and harshness (NVH) characteristics.

Due to the lack of magnets and thus the huge associated potentials, researchers are still struggling to improve these noise, vibration and harshness (NVH) properties, but often they end-up sacrificing the other key-performance indicators: efficiency, power factor, torque ripple.

According to the invention, an apparatus and method is therefore provided to simultaneously improve the noise, vibration and harshness (NVH) characteristic of such a switched reluctance motor (SRM) as well as its efficiency and the power factor.

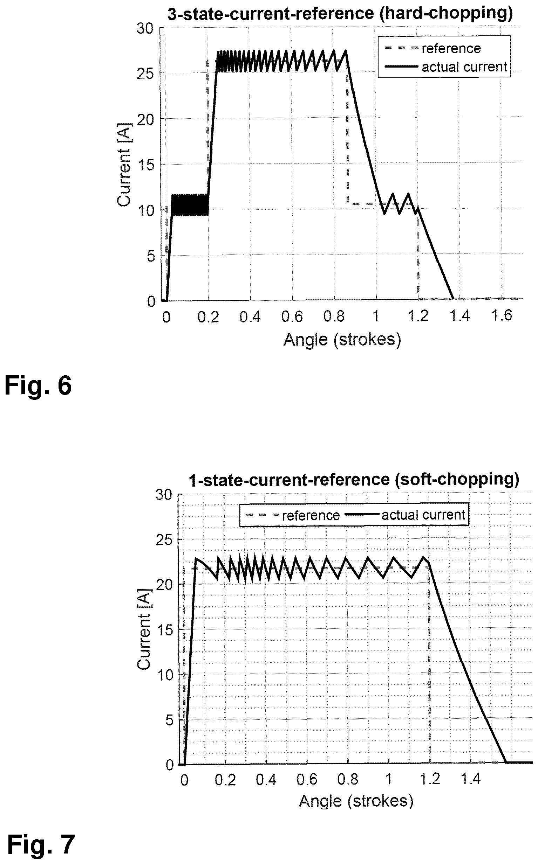

In the conventional case as illustrated by the solid line in Fig. 2, at the turn-on angle and a stroke S = 0, the phase is excited with current, which when achieving its reference will follow it within some pre-imposed hysteresis band, when using variable chopping frequency, or based on a voltage Pulse Width Modulation (PWM)-technique, when using fixed chopping frequency. A phase winding of the switched reluctance motor (SRM) is excited with a reference current until the turn-off angle is reached, when the de-fluxing command is applied and the current is brought as fast as possible to zero by applying a negative voltage. As mentioned before, this case is shown in Fig. 1 by the solid line and further referred to as one-state-current-function as only one reference current is applied so that the current can have only one state. In following Fig. 7 instead of the reference current as in Fig. 2 the flow of the real current is illustrated.

In the new case there are three possible states, namely state-1, state-2 and state-3 as illustrated before, e.g. in Fig. 2, of the current according to the invention. As mentioned before, a dwell period, i.e. the period between the turn-on angle and the turn-off angle of the motor, is divided in three subintervals δ₁, δ₂ and δ₃, wherein a first reference current η₁ is applied in the first subinterval δ₁ to at least one phase winding of the switched reluctance motor (SRM), a second reference current η₂ is applied in the second subinterval δ₂ to the at least one phase winding of the switched reluctance motor (SRM) and a third reference current η₃ is applied in the third subinterval δ₁ to the at least one phase winding of the switched reluctance motor (SRM).

Over at least one such dwell period or conduction period, starting with the turn-on angle and ending with the turn-off angle, up to three different current references η₁ to η₃ can be applied. That means, the first, second and third reference current η₁, η₂ and η₃ can be different in size, wherein the second reference current can be larger than the first and the third reference current. Further, the first and the third reference current can be either different in size or equally great.

Moreover, another three different degrees of freedom (DoFs) can be considered since each pulse and thus each subinterval δ₁, δ₂ and δ₃ can have a different span over the stroke length and corresponding dwell period length. That means, the span over the stroke length of the first subinterval δ₁, the span over the stroke length of the second subinterval δ₂ and the span over the stroke length of the third subinterval δ₂ can be different in size or equally great. The span over the second subinterval δ₂ can be larger than the span over the first subinterval δ₁ and the span over the third subinterval δ₃. Further, the span over the first subinterval δ₁ and the span over the third subinterval δ₃ can be either different in size or equally great.

Over the first subinterval δ₁ one can optimize the efficiency of the motor based on at least one motor-efficiency parameter, as this is the subinterval when the rotor is moving from un-aligned position, i.e. zero torque, and starts to produce torque. As the torque is very low, one can optimize the level of the current such that the copper losses are kept low, in case of copper windings of the motor, while slowly energizing the phase. Over this first subinterval δ₁, similar to the tangential component, which is reflected in the torque, the radial ones or radial forces are also very small. As a motor-efficiency parameter to optimize the efficiency of the motor over the first subinterval δ₁ a conduction loss of the winding(s), a working load of the motor or a working speed of the motor can be used. However, the invention is not restricted to the mentioned examples of motor-efficiency parameters.

One further possibility is to define different weights for the three objectives of the multi-objective optimization.

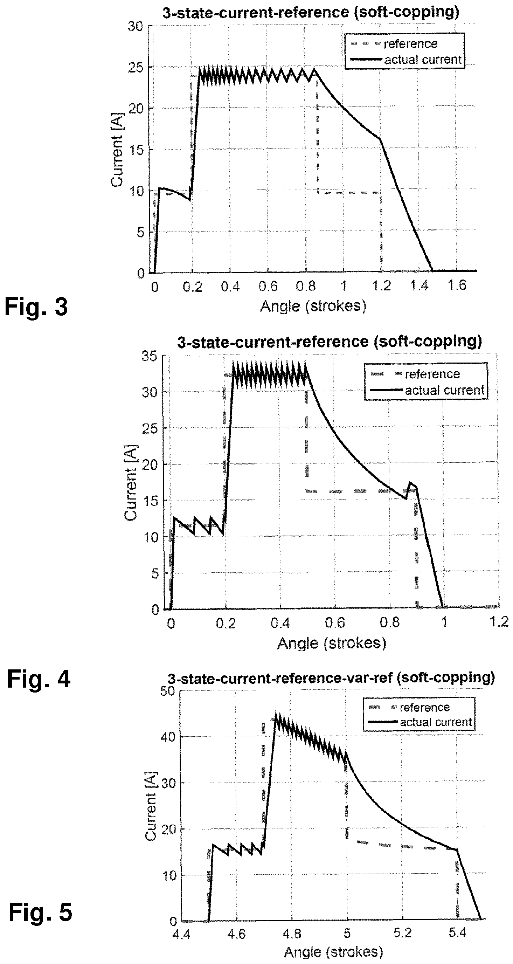

One such example was done with the current waveforms in following Figs. 3-7 where in the multi-objective optimizations the three objectives (having the same weight) were targeted:
1.) the reduction of current consumption thus the improvement of efficiency
2.) reduction of the RMS voltage thus the improvement of power factor and
3.) reduction of the radial force thus the improvement of NVH behavior.

One further example shows the current waveform in case of soft chopping where the reduction of the radial force had a higher weight in the overall objective functions, which means that the radial force will be drastically reduced at the expense of no improvement neither of efficiency nor that of the power factor. The current waveform is shown win Fig. 3.

During the second subinterval δ₂ the motor operates at its maximum torque capability, therefore it makes sense or it is preferred to inject as much current as needed to develop the required torque in the system. The radial component of electromagnetic force is also increasing but it is still significantly lower than the maximum possible value which happens to be when the rotor pole is perfectly aligned with the excited stator pole. Over the second subinterval δ₂ one can optimize the torque production based on at least one torque-parameter.

As a torque-parameter to optimize torque production the torque T of the motor, a tangential component of an electromagnetic force produced by the motor, a radial component of an electromagnetic force produced by the motor, a load of the motor or a working speed of the motor can be used. However, the invention is not restricted to the mentioned examples of torque-parameters.

Over the third subinterval δ₃ the reference current is significantly decreased to a value which can be zero or larger than zero as shown in Fig. 2, thus reducing the overall value of the radial force. Over the third subinterval δ₃ one can optimize the noise, vibration and harshness (NVH) characteristic based on at least one noise-and/or-vibration-parameter. As a noise-and/or-vibration-parameter a tangential component of an electromagnetic force produced by the motor, a radial component of an electromagnetic force produced by the motor, a load of the motor or a working speed of the motor can be used. However, the invention is not restricted to the mentioned examples of noise-and/or-vibration-parameters.

In Figs. 3, 4, 5 and 6 soft-chopping and hard-chopping of the current which tracks the new reference function referred to as three-state-current function and indicated by the dashed line in Fig. 2 is illustrated.

For a comparison in Fig. 7 soft-chopping of the current which tracks the standard function referred to as one-state-current function and indicated by the solid line in Fig. 2 is illustrated. Furthermore, in Fig. 4, another version of Fig. 3 is shown in which during the third state, the current has enough time to reach its reference and is further soft-chopped around that reference till the turn-off point is reached.

In Figs. 3 to 7 as well as before in Fig. 2, the X-axis indicates the stroke and thus the corresponding angle of the motor and the Y-axis indicates the current in Ampere applied to the switched reluctance motor (SRM). However, in the example shown in Figs. 3, 6 and 7, the dwell period starts with a turn-on angle and a corresponding stroke S = 0 and ends with a turn-off angle and a corresponding stroke of, e.g., S = 1.2 in contrast to the example in Fig. 2. In Fig. 4, the dwell period stars for example with a turn-on angle at a stroke S = 0, wherein the turn-off angle is at a stroke S=0.9.

Besides the ideas aspects of the invention mentioned before regarding the multi-objective optimization, one more aspect of the invention related to Fig. 4 is that it shows, in respect with other figures, a different -off point , which proves once again that the -on and -off points are degrees of freedom and they can be adjusted in order to fulfill different objectives.

Further, the dashed (grey) line in Figs. 3 to 7 indicates the reference current and the solid (black) line the actual current.

As shown in Fig. 3, the phase current or third reference current η₃ can either slowly decreased down to a reference value, when applying soft chopping (0V), or as sown in Fig. 6 quickly decreased down to a reference value, when applying hard-chopping (-V_{dc}). This third reference current η₃ value can be optimized, e.g., to minimize the radial force while still developing the remaining portion of the torque which is needed to achieve a required average torque value.

As shown in Figs. 3 and 4, where the length of the subintervals δ₁, to δ₃, as well as the magnitude of the reference current η₁ to η₃ have all different values. The resulted average torque will be the same, the forces, efficiency and power factor different.

The third reference current η₃ is therefore not necessarily zero but a value larger than zero and preferably a value larger than zero at which an optimum is reached between a minimum of the radial force and a certain value of torque required to achieve the required or predetermined average torque as illustrated in Figs. 3 and 6.

As mentioned before, a comparable case is shown in Fig. 2 by a dashed line and further referred to as three-state-current-function as the current or reference current can have three different states and thus non-zero values.

Based on this, one can denote the first subinterval δ₁ as the efficiency control zone, the second subinterval δ₂ as the torque production zone and ultimately the third subinterval δ₃ as the radial force and thus the noise vibration and harshness (NVH) control zone.

It is well known that switched reluctance motors (SRM) have an inductance which is strongly nonlinear and it is increasing as the rotor pole is aligning with the excited stator pole. For the conventional one-state rectangular current control, this means that as the current approaches the turn-off point or turn-off angle, the phase will have to be longer supplied with voltage to maintain the same reference value.

On the other hand, the new control method, in particular in soft-chopping mode, exploits the increased inductance as depending on the working speed and load it allows the operation in the third subinterval δ₃ with zero or reduced root mean square (rms) phase voltage thus bringing improvement in terms of power factor.

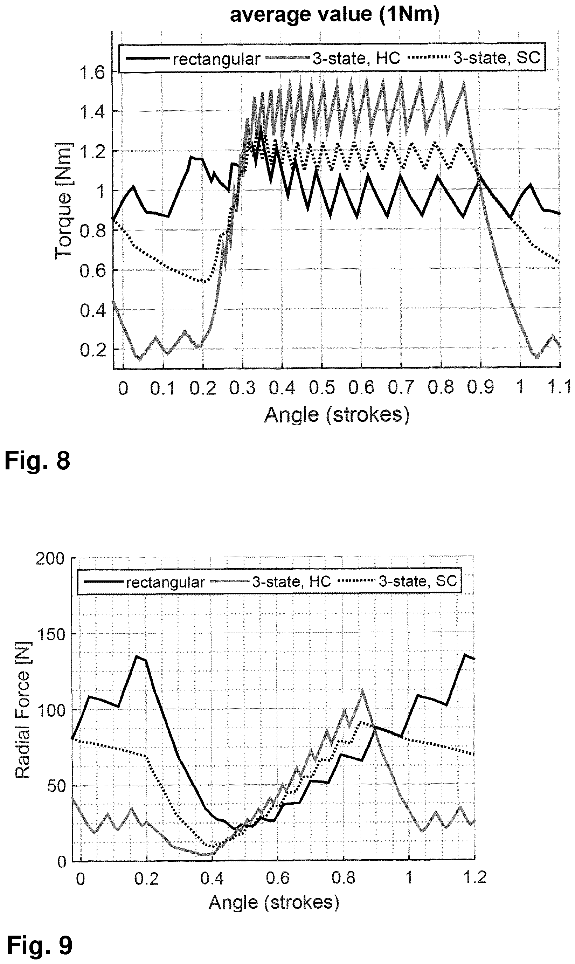

For a better understanding, comparative results are shown in following Figs. 8 to 11 between the newly introduced method and a conventional or one-state rectangular hysteresis current control. Even though not shown here, the superiority of the inventive method is still valid when comparing it with a non-rectangular current control such as those from the class of torque sharing functions, e.g. sine, cosine, cubic, generalized piecewise cubic, exponential.
Fig. 8 shows a diagram in which the X-axis indicates the angle (in strokes) of the motor and the Y-axis indicates the torque in newton meters (Nm) applied to the switched reluctance motor (SRM). In the example as illustrate in Fig. 8 and following Figs. 9, 10 and 11 a stroke S = 0 corresponds to the turn-on angle and a stroke S = 1 corresponds to the turn-off angle of the switched reluctance motor (SRM).

The torque depending on the stroke S and thus the angle of the switched reluctance motor (SRM) of the conventional one-state rectangular hysteresis current control is indicated by a solid black line. Further, the flow of torque depending on the stroke S and thus the angle of the switched reluctance motor (SRM) of the new three-state current control with soft chopping of the current is indicated with a black dotted line and with hard chopping of the current with a grey solid line in Fig. 8.

Further, Fig. 9 shows a corresponding diagram in which the X-axis indicates the angle (in strokes S) of the rotor and the Y-axis indicates the radial force in Newton developed by the switched reluctance motor (SRM). The flow of the radial force depending on the stroke S and thus on the angle of the switched reluctance motor (SRM) of the conventional one-state rectangular hysteresis current control is indicated by a solid black line. Further, the flow of the radial force depending on the stroke S and thus the angle of the switched reluctance motor (SRM) of the new three-state current control with soft chopping of the current is indicated with a black dotted line and with hard chopping of the current with a grey solid line in Fig. 9.

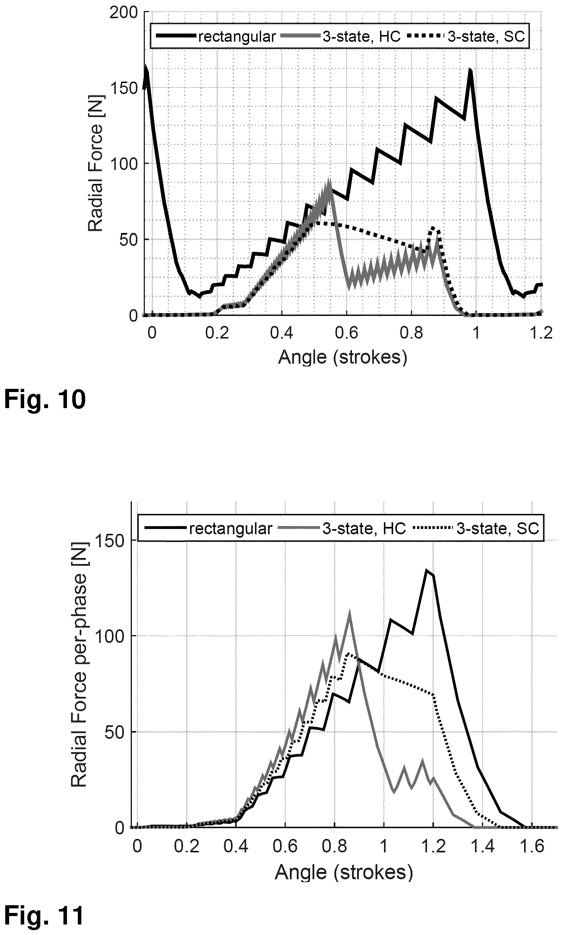

Unlike the Fig. 9 where the optimization is performed with all the three objectives having the same weight, in Fig. 10 a case is shown in which the minimization of the radial force had the highest weight in the weighted objective function. The waveform with the three-state method and soft chopping was obtained using the current provided in Fig. 4.

In Fig. 11 a diagram is shown in which the Y-axis indicates the radial force per phase of the motor and the X-axis indicates the stroke S and thus the corresponding angle of the switched reluctance motor (SRM), when the stator phase is supplied with the currents shown in Figs. 3 to 7.

The radial force per phase of the motor depending on the stroke S and thus on the corresponding angle of the switched reluctance motor (SRM) of the conventional one-state rectangular hysteresis current control is indicated by a black solid line. Further, the flow of the radial force per phase of the motor depending on the stroke S and thus on the corresponding angle of the switched reluctance motor (SRM) of the new three-state current control with soft chopping of the current is indicated with a black dotted line and with hard chopping of the current with a grey solid line in Fig. 11.

In this particular case shown in Figs. 8 and 9, the average value of the radial force is 66.76N, 51.71N, 39.4N for the conventional rectangular hysteresis current control, three-state current control with soft chopping (SC) of the current (SC) and three-state current control with hard chopping (HC), respectively.

Furthermore, for the case where the radial force had the highest weight in the objective function, an average value of 75.35N, 30.05N, 25.0N for the conventional rectangular hysteresis current control, three-state current control with soft chopping (SC) of the current (SC) and three-state current control with hard chopping (HC), respectively. It has to be stated that for the conventional case the current waveform was optimized for minimizing the torque ripple and so it can be concluded that minimizing the torque ripple leads to a higher radial force and thus to a worsening of the NVH behavior.

In comparison with the conventional rectangular case, when applying the new method and chopping the voltage in soft mode, the overall force value is lower as well as the individual harmonics amplitude thus an improved acoustic behavior can be provided. Moreover, for multi-objective optimizations with high weight of the radial force or for single-objective optimization with the radial force as objective, reduction of more than 50% of it can be achieved.

It was checked also with measurements where the sound power level (SPL) was measured for the case when the motor accelerates from 0 rpm to the maximum speed in a given time. Despite the fact that the three-state current control method with hard chopping exhibits the lowest average force, it is still inferior to its soft chopping counterpart as the amplitude of the higher order harmonics increases and ultimately the radiated noise. However this has nothing to do with the three-state method but rather with the way the chopping is done.

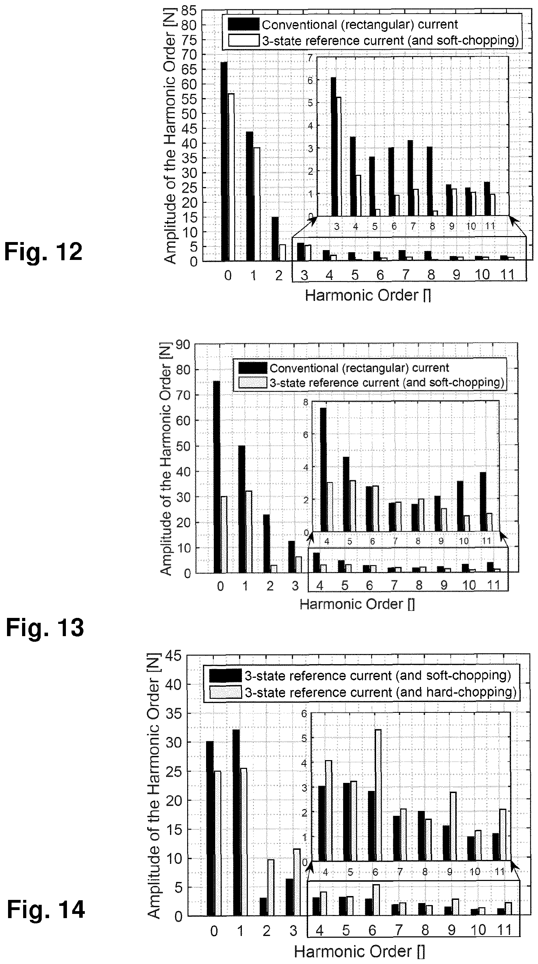

Finally, in Fig. 12, a comparison is illustrated between the most important harmonics of the total radial force, with a amplitude greater than 1% from the direct current (DC)-component, for the conventional one-state rectangular hysteresis current control and for the new three-state current control when applying soft chopping to the current.

Furthermore, in Fig. 13 the harmonic spectrum of the radial force in the one-state and three-state with soft chopping, respectively, is shown. FFT was performed on the force waveforms shown in Fig. 10 whereas for the soft chopping case the current in Fig. 4 was used.

Moreover, in Fig. 14 the comparison between the three-state soft and hard chopping, respectively, is shown, highlighting the fact that even though the later provides a lower overall value of the force, the amplitude of the higher order harmonics exceeds those which results when using soft-chopping which in conjunction with the fact that the human ear is most sensitive to those higher order harmonics will determine a worsening of the qualitative NVH.

At least but not last, it is expected that a combination of hard and soft-chopping (i.e. a hybrid chopping) add another degree of freedom in the optimization procedure of the best current waveform which improves the NVH-behavior. The hybrid chopping is realized by switching between hard and soft at a given or predetermined angular rotor position.

As for the efficiency, again, for this particular case, reported here, when optimizing using equal weights in the multi-objective weighted function the root mean square (rms) current decreases from 14.2A in the conventional case to 13.4A for the new method with a direct impact on the efficiency of +2.5%. Furthermore, lower root mean square (rms) current implicitly means lower conduction losses in the inverter thus increasing also its efficiency.

Finally, regarding the power factor, for the new method with the soft-chopping case, due to the operation in the third subinterval δ₃ region and partially in the first subinterval δ₁ region, where the voltage is zero, the root mean square (rms) phase voltage will decrease with round about 15% with a beneficial effect on the power factor. Moreover, as there is no chopping, the switching losses in inverter will also decrease, one again contributing beneficially to its efficiency.

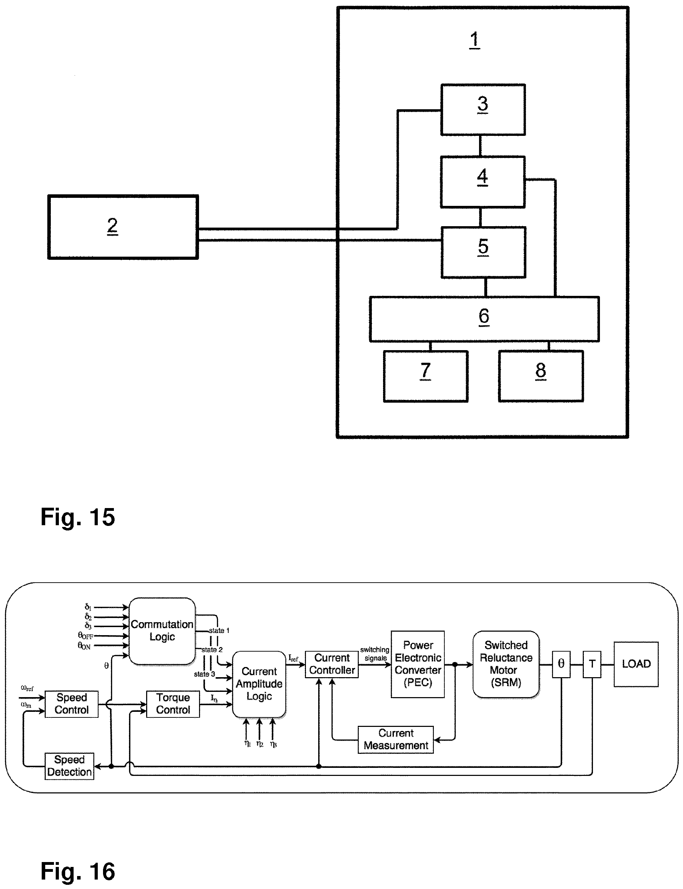

In Fig. 15 an example of an apparatus 1 is disclosed for controlling the current flow of at least one phase winding of a switched reluctance motor (SRM) 2 based in particular on the method described before with respect to Figs. 2 to 11.

The apparatus 1 for controlling the current flow of at least one phase winding of a switched reluctance motor 2 during at least one dwell period of the motor 2 comprises a first sensing means 3 for sensing the angle θ of the motor and/or the corresponding stroke of the motor.

As mentioned before each dwell period of the motor 2 starting with a turn-on angle θₒₙ of the motor and ending with the turn-off angle 6_{off} of the motor, is divided in the first subinterval δ₁ in which the first reference current η₁ is applied to the motor 2, the second subinterval δ₂ in which the second reference current η₂ is applied to the motor 2 and the third subinterval δ₃ in which the third reference current η₃ is applied to the motor 2.

Further, the apparatus 1 comprises means 4 for determining the first, second and third subinterval δ₁, δ₂ and δ₃ based on the angle of the motor and/or the corresponding stroke S of the motor sensed by the first sensing means.

Moreover, the apparatus 1 comprises a second sensing means 5 for sensing at least one motor-efficiency parameter which depends directly or indirectly on the efficiency of the motor 2, at least one torque-parameter which depends directly or indirectly on the torque of the motor 2, and/or at least one noise-and/or-vibration-parameter which depends directly or indirectly on an electromagnetic force produced by the motor 2. Examples of such parameters have been mentioned before with respect to Figs. 2 to 12 and are therefore not repeated.

Further, the apparatus 1 comprises control means 6 for controlling the flow of the first reference current η₁ based on the at least one motor-efficiency parameter during the first subinterval δ₁, the flow of the second reference current η₂ based on the at least one torque-parameter during the second subinterval δ₂, and/or the flow of the third reference current η₃ based on the least one noise-and/or-vibration-parameter during the third subinterval δ₃.

In an embodiment of the invention the control means 6 comprises a storing means 7 in which a look-up table for a flow of the first, second and/or third reference current η₁, η₂, η₃ is stored dependent on the at least one motor-efficiency parameter, the at least one torque-parameter, and the at least one noise-and/or-vibration-parameter, respectively.

In addition or alternatively the control means 6 can also comprises a calculation means 8 to calculate a flow of the first, second and/or third reference current η₁, η₂, η₃ dependent on the at least one motor-efficiency parameter, the at least one torque-parameter, and the at least one noise- and/or-vibration-parameter, respectively. This has the advantage that less memory is required.

In Fig. 16 a diagram is shown, illustrating an example of controlling the current flow of at least one phase winding of a switched reluctance motor (SRM) 2 based in particular on the method described before with respect to Figs. 2 to 11.

A computation logic provides three possible states of the current according to the invention, namely state-1, state-2 and state-3, as illustrated before, e.g. in Fig. 2, to a current amplitude logic. The current amplitude logic further provides a reference current function I_{ref} to a current controller based on a first reference current η₁ in state-1, a second reference current η₂ in state-2, and a third reference current η₃ in state-3. As shown in Fig. 16 a torque control logic provides the current amplitude logic with current function Iₙ.

As mentioned before, a dwell period, i.e. the period between the turn-on angle θₒₙ and the turn-off angle θ_{off} of the motor, is divided in three subintervals δ₁, δ₂ and δ₃, wherein a first reference current η₁ is applied in the first subinterval δ₁ to at least one phase winding of the switched reluctance motor (SRM), a second reference current η₂ is applied in the second subinterval δ₂ to the at least one phase winding of the switched reluctance motor (SRM) and a third reference current η₃ is applied in the third subinterval δ₁ to the at least one phase winding of the switched reluctance motor (SRM). As illustrate in Fig. 16 a power electronic converter (PEC) is provided to control the switched reluctance motor (SRM).

As mentioned before during, e.g., over the second subinterval δ₂ one can optimize the torque production based on at least one torque-parameter. As a torque-parameter to optimize torque production the torque T of the motor, a tangential component of an electromagnetic force produced by the motor, a radial component of an electromagnetic force produced by the motor, a load of the motor or a working speed of the motor can be used. However, the invention is not restricted to the mentioned examples of torque-parameters.

Although the present invention has been fully described above by means of preferred embodiments, it is not limited to the above, but may be modified in a number of ways. In particular, the embodiments of the invention described with respect to Figs. 1 to 16 can be combined with each other, in par separate features of the embodiments can be combined with each other.

### List of reference numerals

- 1: apparatus
- 2: switched reluctance motor
- 3: first sensing means
- 4: means for determining the first, second and third subinterval
- 5: second sensing means
- 6: control means
- 7: storing means
- 8: calculation means

## Claims

1. A method for controlling the current flow of at least one phase winding of a switched reluctance motor (2) during at least one dwell period of the motor, wherein the dwell period starts with a turn-on angle of the motor (2) and ends with the turn-off angle of the motor,
wherein the dwell period is divided in a first subinterval comprising a first reference current, a second subinterval comprising a second reference current and a third subinterval comprising a third reference current,
wherein the flow of the first reference current is controlled based on at least one motor-efficiency parameter which depends on the efficiency of the motor,
wherein the flow of the second reference current is controlled based on at least one torque-parameter which depends on the torque of the motor (2) to control the torque production of the motor, and/or
wherein the flow of the third reference current is controlled based on at least one noise-and/or-vibration-parameter which depends on an electromagnetic force produced by the motor to reduce noise and/or vibration of the motor.

2. Method according to claim 1,
wherein the at least one motor-efficiency parameter to control the flow of the first reference current to increase the motor efficiency during the first subinterval is a conduction loss, in particular a copper loss, of the at least one phase winding as parameter, in particular a copper winding, a load of the motor and/or a working speed of the motor (2).

3. Method according to claims 1 or 2,
wherein the least one torque-parameter to control the flow of the second reference current to control torque production of the motor (2), in particular to increase the torque production of the motor to a maximum of the motor (2) during the second subinterval, is the torque of the motor, a tangential component of an electromagnetic force produced by the motor (2), a radial component of an electromagnetic force produced by the motor (2), a load of the motor (2) and/or a working speed of the motor (2).

4. Method according to claims 1, 2 or 3,
wherein the at least one noise-and/or-vibration-parameter to control the flow of the third reference current to reduce noise and/or vibration of the motor is a tangential component of an electromagnetic force produced by the motor (2), a radial component of an electromagnetic force produced by the motor (2), a load of the motor (2) and/or a working speed of the motor (2).

5. Method according to any of the preceding claims,
wherein the flow of the third reference current is controlled so that the torque is reduced to a predetermined torque value while the radial component is minimized, wherein the predetermined torque value is zero or preferably larger than zero.

6. Method according to any of the preceding claims,
wherein the second reference current is a maximum current and the first reference current and the third reference current are equally great or different in size.

7. Method according to any of the preceding claims,
wherein the third reference current is decreased by soft-chopping or hard chopping.

8. Apparatus (1) for controlling the current flow of at least one phase winding of a switched reluctance motor (2) during at least one dwell period of the motor (2), preferably according to the method as claimed in any of claims 1 to 7,
wherein the dwell period starts with a turn-on angle of the motor (2) and ends with the turn-off angle of the motor (2),
wherein the dwell period is divided in a first subinterval comprising a first reference current, a second subinterval comprising a second reference current and a third subinterval comprising a third reference current, comprising:
- first sensing means (3) for sensing the angle of the motor (2) and/or the corresponding stroke of the motor (2);
- means (4) for determining the first, second and third subinterval based on the angle of the motor and/or the corresponding stroke of the motor sensed by the first sensing means;
- second sensing means (5) for sensing at least one motor-efficiency parameter which depends on the efficiency of the motor, at least one torque-parameter which depends on the torque of the motor (2), and/or at least one noise-and/or-vibration-parameter which depends on an electromagnetic force produced by the motor (2);
- control means (6) for controlling the flow of the first reference current based on the at least one motor-efficiency parameter, the flow of the second reference current based on the at least one torque-parameter, and/or the flow of the third reference current based on the least one noise-and/or-vibration-parameter during the third subinterval.

9. Apparatus according to claim 8,
wherein the control means (6) comprises a storing means (7) in which a look-up table for a flow of the first, second and/or third reference current is stored dependent on the at least one motor-efficiency parameter, the at least one torque-parameter, and the at least one noise-and/or-vibration-parameter, respectively.

10. Apparatus according to claim 8 or 9,
wherein the control means (6) comprises a calculation means (8) to calculate a flow of the first, second and/or third reference current dependent on the at least one motor-efficiency parameter, the at least one torque-parameter, and the at least one noise-and/or-vibration-parameter, respectively.
